# EUROPEAN PATENT APPLICATION

(11) **EP 4 407 673 A1**
(43) Date of publication of application: **31.07.2024**
(21) Application number: 22872460.5
(22) Date of filing: 24.05.2022
(51) Int. Cl.: H01L 23/29, H01L 23/31, C08L 9/06, C08L 63/00, B29C 43/18, B29C 43/34, C08K 3/36

(54) **LIQUID COMPRESSION MOLDING MATERIAL, ELECTRONIC COMPONENT, SEMICONDUCTOR DEVICE AND METHOD FOR PRODUCING SEMICONDUCTOR DEVICE**

(30) Priority: 22.09.2021 JP 2021154478
(71) Applicant: Namics Corporation, Niigata-shi, Niigata 950-3131 (JP)
(72) Inventor: SAITO, Yu, Niigata-shi, Niigata 950-3131 (JP); OE, Takayuki, Niigata-shi, Niigata 950-3131 (JP); KAMIMURA, Tsuyoshi, Niigata-shi, Niigata 950-3131 (JP)
(74) Representative: Mathys & Squire
(86) International application number: PCT/JP2022/021246
(87) International publication number: WO 2023/047702

(57) **Abstract**

Provided is a liquid compression molding material including an epoxy resin composition containing an epoxy resin (A), a curing accelerator (B), a filler (C), and an elastomer (D), in which blending ratio of the filler (C) to the epoxy resin composition is 73.0 mass% or more, and blending ratio of the elastomer (D) to a total of components excluding the filler (C) from the epoxy resin composition is 7.0 mass% or more.

## Description

### TECHNICAL FIELD

The present disclosure relates to a liquid compression molding material, an electronic component, a semiconductor device, and a method for producing the semiconductor device.

### BACKGROUND ART

Most of semiconductor elements such as integrated circuits constituting a semiconductor device are sealed with a sealing material. There are a plurality of molding methods for sealing the semiconductor element. In recent years, opportunities for employing compression molding, which is more suitable for manufacturing a relatively large molded article, for sealing the semiconductor element are increasing. This is due to, for example, spread of wafer-level chip size package technology. This technology is characterized by involving sealing a wafer that is not cut into chips as it is after completion of circuit formation.

In general, a solid resin composition such as a granular resin composition is mainly used for sealing the semiconductor element by compression molding. However, recently, with development of a new compression molding technology, a liquid curable resin composition (so-called liquid compression molding material) is often used. Hereinafter, the liquid compression molding material may be abbreviated as a "liquid compression molding (LCM) material".

As the LCM material, for example, a liquid epoxy resin composition is often used from the viewpoint of securing various properties such as electrical properties, moisture resistance, heat resistance, mechanical properties, and adhesiveness in a well-balanced manner. As such an LCM material, for example, liquid epoxy resin compositions described in PATENT LITERATURES 1 and 2 have been proposed. This LCM material contains, as main components, a resin matrix precursor component (epoxy resin, curing agent, or the like) that forms a resin matrix when the LCM material is cured, and a large amount of filler. That is, after the curing, the resin matrix contains a cured resin matrix precursor component.

### CITATION LIST

### PATENT LITERATURE

PATENT LITERATURE 1: WO 2018/221681 A
PATENT LITERATURE 2: JP-A-2015-105304

### SUMMARY OF INVENTION

### PROBLEMS TO BE SOLVED BY INVENTION

On the other hand, when compression molding is performed using a conventional LCM material, a phenomenon may occur in which a sealing material (cured product of the LCM material) covering a vicinity of a side surface of an electronic element such as a semiconductor element contains only a resin matrix (hereinafter, referred to as a "resin-rich matrix") containing almost no filler. When the resin-rich matrix is formed in the sealing material, there arises a problem in terms of reliability of an electronic device such as a semiconductor device.

The liquid compression molding material according to the present embodiment has been implemented in view of the above circumstances. That is, an object of the present embodiment is to provide a liquid compression molding material capable of suppressing generation of the resin-rich matrix in the sealing material obtained by curing the liquid compression molding material by compression molding. Another object of the present embodiment is to provide an electronic component and a semiconductor device using the liquid compression molding material. Still another object of the present embodiment is to provide a method for manufacturing the semiconductor device using the liquid compression molding material.

### SOLUTION TO PROBLEMS

The above objects are achieved by the present embodiment described below.

That is, a liquid compression molding material according to an embodiment of the present disclosure includes an epoxy resin composition containing an epoxy resin (A), a curing accelerator (B), a filler (C), and an elastomer (D), blending ratio of the filler (C) to the epoxy resin composition is 73.0 mass% or more, and blending ratio of the elastomer (D) to a total of components excluding the filler (C) from the epoxy resin composition is 7.0 mass% or more.

In the liquid compression molding material according to another embodiment of the present disclosure, the elastomer (D) is preferably at least one kind of substance selected from the group consisting of a solid substance and a liquid substance having a viscosity of 110 Pa·s or more at room temperature.

In the liquid compression molding material according to another embodiment of the present disclosure, the blending ratio of the elastomer (D) to the components excluding the filler (C) from the epoxy resin composition is preferably 7.0 mass% to 16.5 mass%.

In the liquid compression molding material according to another embodiment of the present disclosure, the blending ratio of the filler (C) to the epoxy resin composition is preferably 73.0 mass% to 87.5 mass%.

In the liquid compression molding material according to another embodiment of the present disclosure, a viscosity at 120°C is preferably 0.5 Pa s to 40.0 Pa s.

In the liquid compression molding material according to another embodiment of the present disclosure, the curing accelerator (B) preferably contains a nitrogen-containing heterocyclic compound.

The liquid compression molding material according to another embodiment of the present disclosure preferably further contains a curing agent (E).

In the liquid compression molding material according to another embodiment of the present disclosure, the curing agent (E) preferably contains at least one selected from the group consisting of a phenolic curing agent, an amine-based curing agent, and an acid anhydride-based curing agent.

In the liquid compression molding material according to another embodiment of the present disclosure, the epoxy resin (A) preferably contains at least one selected from the group consisting of an aliphatic epoxy resin and an aromatic epoxy resin.

An electronic component according to an embodiment of the present disclosure includes a sealing material containing a cured product of the liquid compression molding material of the present invention.

A semiconductor device according to an embodiment of the present disclosure includes: a substrate; a semiconductor element disposed on the substrate; and the cured product of the liquid compression molding material according to the embodiment of the present disclosure that seals a gap between the semiconductor element and the substrate.

A method for producing a semiconductor device according to an embodiment of the present disclosure includes: filling a gap between a substrate and a semiconductor element disposed on the substrate with the liquid compression molding material according to the embodiment of the present disclosure by a compression molding method; performing press clamping; and curing the liquid compression molding material.

### EFFECTS OF INVENTION

According to the liquid compression molding material according to the present embodiment, it is possible to suppress generation of the resin-rich matrix in the sealing material containing the liquid compression molding material cured by compression molding. In addition, it is possible to provide an electronic component, a semiconductor device, and a method for producing a semiconductor device using the LCM material.

### BRIEF DESCRIPTION OF DRAWINGS

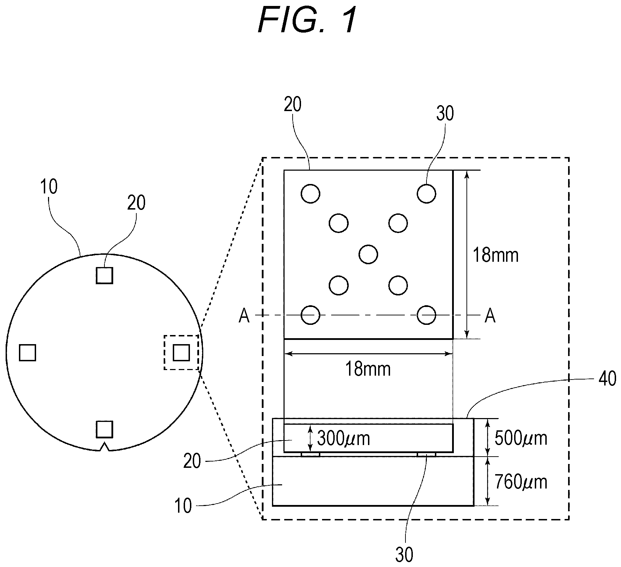

Fig. 1 is a schematic diagram for explaining a method for evaluating a resin-rich matrix. Here, the left side of Fig. 1 is a schematic plan view illustrating an arrangement position of a silicon chip on a silicon wafer surface in a molded article including a sealing layer (a cured layer of an LCM material). The sealing layer resin-seals the silicon chip disposed via a spacer on the silicon wafer. Further, the right side of Fig. 1 is an enlarged view of a range surrounded by a dotted line on the left side of Fig. 1. Here, a view illustrated in an upper part on the right side of Fig. 1 is an enlarged plan view illustrating an arrangement position of the spacer with respect to a planar direction of the silicon chip. Further, a view illustrated in a lower part on the right side of Fig. 1 is an enlarged cross-sectional view illustrating a cut surface of the molded article at a position corresponding to a line A-A in a schematic plan view in the upper part on the right side of Fig. 1.

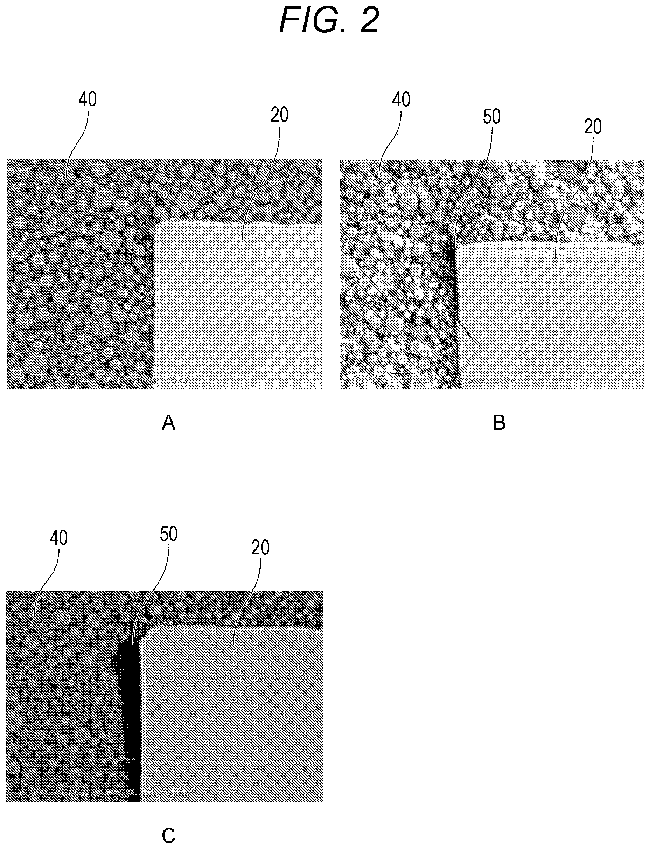

Figs. 2A, 2B, and 2C are SEM images illustrating an observation example of the resin-rich matrix. Here, Fig. 2A is an SEM image illustrating an example in which no resin-rich matrix is observed on a side surface of the silicon chip. Fig. 2B is an SEM image illustrating an example in which a resin-rich matrix having a maximum thickness of less than 2 µm is observed on the side surface of the silicon chip. Fig. 2C is an SEM image illustrating an example in which a resin-rich matrix having a maximum thickness of 2 µm or more is observed on the side surface of the silicon chip.

### DESCRIPTION OF EMBODIMENTS

An LCM material according to the present embodiment includes an epoxy resin composition containing an epoxy resin (A), a curing accelerator (B), a filler (C), and an elastomer (D). Blending ratio of the filler (C) to the epoxy resin composition is 73.0 mass% or more. In addition, the blending ratio of the elastomer (D) to a total of components excluding the filler (C) from the LCM material is 7.0 mass% or more. Thus, even when compression molding is performed using the LCM material, it is possible to suppress generation of a resin-rich matrix in a sealing material covering a vicinity of a side surface of an electronic element.

The reason why the above-described effects can be obtained is not clear. However, the present inventors estimate the reason as follows. First, the present inventors examined the cause of the generation of the resin-rich matrix. As a result, the present inventors speculated that the resin-rich matrix is caused by the fact that a phenomenon shown in the following (1) and a phenomenon shown in the following (2) occur continuously.
(1) During compression molding, since the LCM material flowing into the electronic element so as to cover the side surface of the electronic element is cured and shrunk, the side surface of the electronic element and the cured LCM material or the LCM material being cured are peeled off (hereinafter, may be referred to as a "peeling phenomenon".).
(2) An uncured curable component flowing into a gap formed by peeling between the side surface of the electronic element and the cured or currently curing LCM material and containing almost no filler is cured. As a result, the curable component containing almost no cured filler forms the resin-rich matrix.

Therefore, in order to suppress the generation of the resin-rich matrix, the present inventors have studied to suppress the blending ratio of the curable component (component whose volume shrinks when the LCM material is cured) contained in the LCM material as low as possible. For this purpose, it was considered to be important to increase the blending ratio of a non-curable component (component whose volume does not shrink during the curing) including a combination of the filler (C) and the elastomer (D) as much as possible. Then, as a result of trial and error, it was found that the resin-rich matrix can be effectively suppressed when the following conditions (i) and (ii) are satisfied.
(i) The blending ratio of the filler (C) to the epoxy resin composition contained in the LCM material is 73.0 mass% or more.
(ii) The blending ratio of the elastomer (D) to the total of components excluding the filler (C) from the epoxy resin composition contained in the LCM material is 7.0 mass% or more.

Note that both the filler (C) and the elastomer (D) are non-curable components that do not undergo volume shrinkage during the curing. Therefore, it is also conceivable to suppress the generation of the resin-rich matrix by using a large amount of only one of the filler and the elastomer. However, in the present embodiment, it is extremely important to use a combination of the conditions (i) and (ii) so as to satisfy the both conditions. First, when only a large amount of the elastomer (D) is used without using the filler (C), a thickening effect caused by addition of the filler (C) is not obtained at all. Therefore, viscosity suitable for compression molding cannot be secured. That is, the epoxy resin composition containing no filler (C) cannot be used as the LCM material in the first place. In contrast, when only a large amount of the filler (C) is used without using the elastomer (D), proportion of the curable component including the epoxy resin (A) and the like in a composition of the LCM material is relatively small as an addition amount of the filler (C) is larger. Therefore, the volume shrinkage in the resin matrix at the time of curing the LCM material can be further reduced. However, only by increasing the addition amount of the filler (C), an amount of the volume shrinkage at the time of curing can be merely reduced, and occurrence of the volume shrinkage itself cannot be suppressed. Therefore, it is difficult to avoid occurrence of the peeling phenomenon caused by the volume shrinkage. Therefore, as a result, it is difficult to suppress the generation of the resin-rich matrix only by increasing the addition amount of the filler (C).

On the other hand, at the time of curing, the elastomer (D) as an organic component and the curable component such as the epoxy resin (A) as an organic component react with each other and are bonded to each other. Thus, it is considered that the resin matrix containing the cured curable component is deformed after curing. Then, accordingly, it is considered that an elastomer matrix (elastomer (D) contained in a cured product of the LCM material) bonded to the resin matrix is also deformed. That is, it is considered that when the LCM material is cured, the resin matrix is deformed so that volume of the resin matrix shrinks more than before curing. On the other hand, it is considered that the elastomer matrix that is easily deformed expands and deforms to cancel the volume shrinkage in the resin matrix. Therefore, it is considered that the peeling phenomenon (phenomenon shown in the above (1)) is less likely to occur when the elastomer matrix is present in an amount sufficient to cancel the volume shrinkage in the resin matrix after the LCM material is cured. Then, as a result, it is considered that the generation of the resin-rich matrix can also be suppressed.

Here, according to the condition (i), proportion of the resin matrix shrunk in volume contained in the cured product of the LCM material is equal to or less than a certain amount. Thus, it is presumed that the condition (i) contributes to more effectively exhibiting an action of canceling the volume shrinkage in the resin matrix due to the addition of the elastomer (D). In addition, it is presumed that the condition (ii) contributes to securing the elastomer matrix in an amount sufficient to be able to absorb the volume shrinkage in the resin matrix to such an extent that the occurrence of the peeling phenomenon can be suppressed.

Note that when the elastomer (D) to be blended in the LCM material is a liquid substance having a viscosity of 110 Pa·s or more at room temperature, it is considered that elastomer molecules are incorporated into a crosslinked structure formed by a curable component such as the epoxy resin (A) when the LCM material is cured. In this case, the resin matrix having elasticity is formed. Therefore, even in such a case, it is considered that when a sufficient amount of the elastomer (D) is blended in the LCM material, the volume shrinkage in the resin matrix associated with a curing reaction is canceled by the elasticity of the resin matrix itself. Thus, it is considered that the occurrence of the peeling phenomenon and the generation of the resin-rich matrix can also be suppressed.

Note that in the present disclosure, the "liquid compression molding material (LCM material)" means the liquid curable resin composition that has a viscosity of 2000 Pa s or less at room temperature (25°C) and can be used in a compression molding process. Therefore, the viscosity of the liquid compression molding material of the present embodiment at room temperature is not particularly limited as long as it is 2000 Pa s or less. However, the viscosity is preferably 1000 Pa s or less, more preferably 700 Pa s or less, and still more preferably 500 Pa·s or less from the viewpoint of workability and the like in producing the liquid compression molding material. Note that a lower limit of the viscosity at room temperature is not particularly limited. However, from the viewpoint of handleability and the like, the lower limit is 50 Pa s, and more preferably 100 Pa·s.

Further, a viscosity range of the liquid compression molding material at 120°C is preferably 0.5 Pa·s to 40.0 Pa·s, more preferably 0.5 Pa·s to 20.0 Pa·s, and still more preferably 0.8 Pa s to 8.0 Pa s. When the viscosity at 120°C is 0.5 Pa s or more, it is possible to easily suppress the liquid compression molding material from flowing out of a mold when compression molding the LCM material according to the present embodiment. Further, when the viscosity at 120°C is 40.0 Pa s or less, it is possible to easily suppress filling defects of the liquid compression molding material due to high viscosity during the compression molding. Note that a method for measuring the viscosity at room temperature and 120°C will be described later in detail.

Next, details of various components contained in the liquid compression molding material according to the present embodiment will be described below.

### (A) Epoxy resin

The epoxy resin (A) that can be used for the LCM material according to the present embodiment is not particularly limited as long as it is one of various epoxy resins generally used for semiconductor sealing. However, from the viewpoint of reliability (thermal cycle resistance) and the like, a polyfunctional epoxy resin (an epoxy resin having two or more epoxy groups in one molecule) is particularly preferably used as the epoxy resin. Further, as the epoxy resin used for the LCM material according to the present embodiment, only one kind of epoxy resin may be used. Alternatively, two or more epoxy resins appropriately combined may be used. One molecule of the epoxy resin only needs to contain at least one epoxy group. The number of epoxy groups is usually preferably 2 or more. Note that an upper limit of the number of epoxy groups is not particularly limited. The upper limit of the number of epoxy groups is usually preferably 5 or less. The epoxy group is not particularly limited as long as it is one of various epoxy resins generally used for semiconductor sealing. The epoxy resin only needs to be one of various epoxy resins generally used for semiconductor sealing, and is not particularly limited.

Further, in preparation of the LCM material, a single epoxy resin can be used as a raw material. However, in addition to this, it is also possible to use a mixed composition (masterbatch) obtained by blending and dispersing core-shell type rubber particles as the elastomer in the epoxy resin at a high concentration. Note that details of the masterbatch will be described later.

The epoxy resin (A) is not particularly limited as long as it is various epoxy resins generally used for semiconductor sealing. The epoxy resin (A) only needs to be one of various epoxy resins generally used for semiconductor sealing, and is not particularly limited.

As the epoxy resin (A), an aliphatic epoxy resin and/or an aromatic epoxy resin can be used. Preferably, both are used in combination. Examples of the aromatic epoxy resin include: bisphenol A type epoxy resins such as p-glycidyloxyphenyldimethyltrisphenol A diglycidyl ether; bisphenol F type epoxy resin; novolac type epoxy resin; fluorene type epoxy resin; biphenyl aralkyl epoxy resin; diepoxy resins such as p-tert-butyl phenyl glycidyl ether and 1,4-phenyldimethanol diglycidyl ether; biphenyl type epoxy resins such as 3,3',5,5'-tetramethyl-4,4'-diglycidyloxybiphenyl; aminophenol type epoxy resins such as diglycidyl aniline, diglycidyl toluidine, triglycidyl-p-aminophenol and tetraglycidyl-m-xylylenediamine; and naphthalene type epoxy resins. The epoxy resin that can be used is not limited to the epoxy resins described above.

Among them, the bisphenol F type epoxy resin, the bisphenol A type epoxy resin, the biphenyl type epoxy resin, the aminophenol type epoxy resin, and the naphthalene type epoxy resin are suitably used.

Further, examples of the aliphatic epoxy resin include: diepoxy resins such as polytetramethylene glycol diglycidyl ether, (poly)propylene glycol diglycidyl ether, butanediol diglycidyl ether, neopentyl glycol diglycidyl ether, 1,6-hexanediol diglycidyl ether, trimethylolpropane diglycidyl ether, polytetramethylene ether glycol diglycidyl ether, glycerin diglycidyl ether, and neopentyl glycol diglycidyl ether; triepoxy resins such as trimethylolpropane triglycidyl ether and glycerin triglycidyl ether; alicyclic epoxy resins such as vinyl(3,4-cyclohexene)dioxide and 2-(3,4-epoxycyclohexyl)-5,1-spiro-(3,4-epoxycyclohexyl)-m-dioxane; glycidyl amine epoxy resins such as tetraglycidyl bis(aminomethyl)cyclohexane; hydantoin type epoxy resin such as 1,3-diglycidyl-5-methyl-5-ethyl hydantoin; and epoxy resins having a silicone skeleton such as 1,3-bis(3-glycidoxypropyl)-1,1,3,3-tetramethyldisiloxane.

Among them, polytetramethylene glycol diglycidyl ether, (poly)propylene glycol diglycidyl ether, 1,4-hexanediol diglycidyl ether, 1,4-butanediol diglycidyl ether, (poly)ethylene glycol diglycidyl ether, and pentaerythritol diglycidyl ether are suitable examples.

### (B) Curing accelerator

The curing accelerator (B) is not particularly limited as long as it is one of various curing accelerators generally used. Examples of the curing accelerator (B) include: a nitrogen-containing heterocyclic curing accelerator (including adducted or microencapsulated types with epoxy resins or isocyanate resins) such as an imidazole compound; a tertiary amine-based curing accelerator; and a phosphorus compound-based curing accelerator. In particular, the nitrogen-containing heterocyclic curing accelerator is preferable from the viewpoint of reliability (thermal cycle resistance). As the curing accelerator to be blended in the LCM material, only one kind of curing accelerator can be used. Alternatively, two or more curing accelerators may be used in combination. The blending ratio of the curing accelerator is not particularly limited. A preferable blending ratio is 2.0 mass% to 8.0 mass%, and a more preferable blending ratio is 2.5 mass% to 6.0 mass% based on the total of components excluding the filler from the LCM material.

Specific examples of the nitrogen-containing heterocyclic curing accelerator (nitrogen-containing heterocyclic compound) include imidazole compounds such as 2-methylimidazole, 2-undecylimidazole, 2-heptadecylimidazole, 2-ethyl-4-methylimidazole, 2-phenylimidazole, 2-phenyl-4-methylimidazole, 2-phenyl-4,5-dihydroxymethylimidazole, 2-phenyl-4-methyl-5-hydroxymethylimidazole, 1-cyanoethyl -2-undecylimidazole, 1-cyanoethyl-2-ethyl-4-imidazole, 2-phenylimidazole, 1-benzyl-2-phenylimidazole, benzimidazole, 2,4-diamino-6-[2'-methylimidazolyl-(1')]ethyl-s-triazine, 2-phenyl-4,5-dihydroxymethylimidazole, and 2,3-dihydro-1H-pyrrolo[1,2-a]benzimidazole. More specific examples include 2MZ, 2P4MZ, and 2E4MZ (all products manufactured by Shikoku Chemicals Corporation, trade names). Further, examples of the nitrogen-containing heterocyclic curing accelerator other than the imidazole compound include diazabicycloundecene (DBU), DBU-phenol salt, DBU-octylate, DBU-p-toluenesulfonate, DBU-formate, DBU-orthophthalate, DBU-phenol novolac resin salt, DBU-based tetraphenylborate salt, diazabicyclononene (DBN), DBN-phenol novolac resin salt, diazabicyclooctane, pyrazole, oxazole, thiazole, imidazoline, pyrazine, morpholine, thiazine, indole, isoindole, purine, quinoline, isoquinoline, quinoxaline, cinnoline, and pteridine.

Further, as the imidazole compound, an encapsulated imidazole called a microcapsule-type imidazole or an epoxy adduct-type imidazole can also be used. That is, an encapsulated imidazole-based latent curing agent obtained by adduct formation of the imidazole compound with urea or an isocyanate compound and further blocking a surface of the adduct product with the isocyanate compound can also be used. Alternatively, the encapsulated imidazole-based latent curing agent obtained by blocking the surface of the imidazole compound adducted with an epoxy compound with the isocyanate compound can also be used. Specific examples of the above-described imidazole compounds include Novacure HX3941HP, Novacure HXA3042HP, Novacure HXA3922HP, Novacure HXA3792, Novacure HX3748, Novacure HX3721, Novacure HX3722, Novacure HX3088, Novacure HX3741, Novacure HX3742, and Novacure HX3613 (all products are manufactured by Asahi Kasei Chemicals Corporation, trade names), AJICURE PN-23J and AJICURE PN-40J (all products manufactured by Ajinomoto Fine-Techno Co.,Inc., trade names), and Fujicure FXR-1121 (manufactured by T&K TOKA Corporation, trade name).

### (C) Filler

The filler (C) is not particularly limited as long as the filler is a substance having functions of lowering a linear expansion coefficient of the cured product (sealing material) of the LCM material by being added to the LCM material and suppressing the volume shrinkage in the resin matrix caused by the curing reaction of the LCM material. Specific examples of the filler (C) include various inorganic particles including a silica filler and an alumina filler. In particular, the silica filler is preferable because it can increase a filling amount. Further, the surface of the filler (C) may be treated with, for example, a silane coupling agent. Note that the filler (C) may further have other functions such as colorability in addition to the functions described above. Examples of such a filler (C) may also include an inorganic pigment such as a white pigment. Examples of such an inorganic pigment include magnesia, titania, zirconia, boron nitride, aluminum nitride, titanium oxide, magnesium oxide, zinc oxide, diamond, potassium titanate, magnesium sulfate, sepiolite, xonolite, aluminum borate, calcium carbonate, titanium oxide, barium sulfate, zinc oxide, magnesium hydroxide, barium titanate, and zirconia oxide.

An average particle diameter of the filler (C) is not particularly limited. The average particle diameter is preferably 0.1 µm to 15.0 µm. The average particle diameter is more preferably 0.3 µm to 10.0 µm. A shape of the filler (C) is not particularly limited. For example, fillers in any of spherical, irregular, and flaky forms can be used. Note that in the present embodiment, the average particle diameter of the filler (C) means a volume average particle diameter D50 (a particle diameter at which a cumulative distribution rate from a small diameter side in a particle size distribution is 50%) value measured using a laser diffraction particle size distribution measuring apparatus (LS 13320 manufactured by Beckman Coulter, Inc.). In measurement, a sample for measurement can be prepared by dispersing 5 mg of filler blended in 50 mg of a dispersant for 10 minutes using an ultrasonic disperser. The prepared sample was measured under the conditions of a flow rate of 50 ml/sec, a measurement time of 90 seconds, pure water as a solvent, and a solvent refractive index of 1.333.

The blending ratio of the filler (C) is 73.0 mass% or more, more preferably 77.5 mass% or more, still more preferably 79.0 mass% or more, and particularly preferably 80.0 mass% or more based on the epoxy resin composition constituting the LCM material (100 mass%). When the blending ratio of the elastomer (D) to the total of the components excluding the filler from the epoxy resin composition is 7.0 mass% or more, the generation of the resin-rich matrix can be suppressed by further setting the blending ratio of the filler (C) to the LCM material to 73.0 mass% or more. On the other hand, an upper limit of the blending ratio of the filler (C) is not particularly limited. However, from the viewpoint of easily securing an appropriate viscosity as the LCM material or from the viewpoint of improving workability in preparing the LCM material, the upper limit is preferably 87.5 mass% or less, and more preferably 86.0 mass% or less.

### (D) Elastomer

As the elastomer (D), any known thermosetting elastomer can be used as long as it is a material having elasticity at least after the LCM material is cured. Examples of the elastomer (D) include the core-shell type rubber particles, a silicone resin, and a butadiene acrylonitrile copolymer. Among these elastomers, the core-shell type rubber particles are suitably used from the viewpoints of imparting injectability to the LCM material, suppressing peeling of the cured LCM material (sealing material) from an electronic device, and suppressing migration, in addition to an effect of suppressing the generation of the resin-rich matrix. Note that properties of the elastomer (D) before curing the LCM material is not particularly limited. Any substance can be used as long as it is a solid substance or a liquid substance having a viscosity of 110 Pa·s or more at room temperature. Note that it is presumed that the liquid substance is changed to a solid substance during curing of the LCM material, and after curing, the elastomer molecules are incorporated into the crosslinked structure of the epoxy resin.

Examples of combination of a core constituting the core-shell type rubber particles and a shell covering the core include (core, shell) = (polybutadiene resin, acrylic copolymer) and (silicone resin, acrylic copolymer). Among these combinations, (core, shell) = (polybutadiene resin, acrylic copolymer) is suitably used because it has a low elastic modulus within a use temperature range of the LCM material, and therefore shrinkage stress during curing of the LCM material can be reduced.

When the core-shell type rubber particles are used as the elastomer (D), a mixed composition (masterbatch) can also be used as a raw material for use in the preparation of the LCM material. This masterbatch can be prepared by masterbatch processing in which the core-shell type rubber particles are blended and dispersed in the epoxy resin. In the masterbatch processing, as other components other than the core-shell type rubber particles and the epoxy resin, if necessary, for example, the curing agent such as an acid anhydride can also be used in combination.

The epoxy resin used for the masterbatch processing is not particularly limited. A bisphenol-type epoxy resin is suitably used. Further, examples of the bisphenol-type epoxy resin include the bisphenol A type epoxy resin and the bisphenol F type epoxy resin. Among them, the bisphenol F type epoxy resin is more suitably used.

The blending ratio of the elastomer (D) is 7.0 mass% or more, preferably 8.0 mass% or more, and more preferably 11.0 mass% or more based on the total (100 mass%) of the components excluding the filler (C) from the epoxy resin composition constituting the LCM material. When the blending ratio of the filler (C) to the epoxy resin composition is 73.0 mass% or more, the generation of the resin-rich matrix can be suppressed by further setting the blending ratio of the elastomer (D) to 7.0 mass% or more. On the other hand, an upper limit of the blending ratio of the elastomer (D) is not particularly limited. The upper limit is preferably 16.5 mass% or less, and more preferably 15.0 mass% or less from the viewpoint of suppressing the volume shrinkage in the resin matrix during curing of the LCM material and improving the workability in preparing the LCM material.

### Other components

In the LCM material of the present embodiment, other components other than the components A to D and the solvent may be appropriately blended as necessary. Note that the solvent is not used for the LCM material of the present embodiment. The other components are not particularly limited. In particular, a curing agent (E) can be suitably used. Further, examples of other components (other additives (F)) other than the curing agent (E) include a coupling agent, an ion trapping agent, a leveling agent, an antioxidant, an antifoaming agent, a flame retardant, a colorant (however, the inorganic pigment functioning also as the filler (C) is excluded), and a reactive diluent. The type and blending amount of the other additives (F) can be determined according to a conventional method. Note that when the other additives (F) are further used, the total content ratio of the other additives (F) contained in the LCM material of the present embodiment is generally more than 0 mass% and 3.5 mass% or less.

### (E) Curing agent

The curing agent (E) is not particularly limited as long as it is one of various curing agents generally used. Examples of the curing agent that can be used include an amine-based curing agent, an acid anhydride-based curing agent, and a phenolic curing agent.

Blending amount of the curing agent (E) is preferably determined so that a stoichiometric equivalent ratio with the epoxy resin (curing agent equivalent/epoxy group equivalent) is 0.01 to 1.00. The equivalent ratio is more preferably 0.01 to 0.50. The equivalent ratio is still more preferably 0.08 to 0.30.

Specific examples of the amine-based curing agent include: aliphatic polyamines such as triethylenetetraamine, tetraethylenepentamine, m-xylenediamine, trimethylhexamethylenediamine, and 2-methylpentamethylenediamine; alicyclic polyamines such as isophoronediamine, 1,3-bisaminomethylcyclohexane, bis(4-aminocyclohexyl)methane, norbornenediamine, and 1,2-diaminocyclohexane; piperazine-type polyamines such as N-aminoethylpiperazine and 1,4-bis(2-amino-2-methylpropyl)piperazine; and aromatic polyamines such as diethyltoluenediamine, dimethylthiotoluenediamine, 4,4'-diamino-3,3'-diethyldiphenylmethane, bis(methylthio)toluenediamine, diaminodiphenylmethane, m-phenylenediamine, diaminodiphenylsulfone, diethyltolueneamine, trimethylene bis(4-aminobenzoate), and polytetramethylene oxide-di-p-aminobenzoate. Further, examples of commercially available products include EPICURE-W and EPICURE-Z (Yuka-Shell Epoxy Co., Ltd., trade names), jER CURE (registered trademark)-W and jER CURE (registered trademark)-Z (Mitsubishi Chemical Corporation, trade names), KAYAHARD A-A, KAYAHARD A-B, and KAYAHARD A-S (Nippon Kayaku Co., Ltd., trade names), TOHTO AMINE HM-205 (NIPPON STEEL & SUMIKIN CHEMICAL CO., LTD., trade name), ADEKA HARDENER EH-101 (ADEKA CORPORATION, trade name), Epomic Q-640 and Epomic Q-643 (Mitsui Chemicals, Inc., trade names), DETDA80 (Lonza, trade name), and TOHTO AMINE HM-205 (NIPPON STEEL & SUMIKIN CHEMICAL CO., LTD., trade name).

Specific examples of the acid anhydride-based curing agent include: alkylated tetrahydrophthalic anhydrides such as methyltetrahydrophthalic anhydride, methylhexahydrophthalic anhydride, and methyltetrahydrophthalic anhydride; hexahydrophthalic anhydride; methylhymic anhydride; succinic anhydride substituted with an alkenyl group; methylnadic anhydride; and glutaric anhydride.

Specific examples of the phenolic curing agent include a monomer, an oligomer, and a polymer having a phenolic hydroxyl group. More specific examples include phenol novolac resins, alkylated and allylated products of the phenol novolac resins, cresol novolac resins, phenol aralkyl (including phenylene or biphenylene skeleton) resins, naphthol aralkyl resins, triphenol methane resins, and dicyclopentadiene type phenol resins.

The LCM material of the present embodiment is prepared by mixing and stirring components as raw materials. A mixing and stirring method is not particularly limited. A known method can be used. For example, a roll mill can be used. Further, when the epoxy resin (A) used as the raw material is in a solid state, the epoxy resin (A) is liquefied by, for example, heat treatment before mixing with other components. Further, in the preparation of the LCM material, all the components as the raw materials can be mixed at once. Alternatively, a primary mixture is prepared by mixing some components selected from all the components to be the raw materials, and the remaining components may be mixed with the primary mixture. For example, when it is difficult to uniformly disperse the filler (C) in the epoxy resin (A), the remaining components may be mixed with the primary mixture prepared by mixing the epoxy resin (A) and the filler (C).

The LCM material of the present embodiment can be widely applied to resin sealing of various electronic components such as semiconductor elements or LED packages. In addition, the resin sealing of the electronic component can be performed by compression molding using the LCM material of the present embodiment. In compression molding, an inside of the mold is filled with a liquid epoxy resin composition (the LCM material) in advance. At the same time, a member to be resin-sealed is disposed in the mold. Thereafter, press clamping is performed. Unlike injection molding or the like, the compression molding does not require a flow path (a gate, a runner, or the like) for resin supply. In this respect, the compression molding has a feature that use efficiency of the epoxy resin composition is nearly 100%.

The electronic component prepared using the LCM material of the present embodiment includes the cured product of the LCM material of the present embodiment. In addition to this, the electronic component further includes, for example, an electronic element such as a semiconductor element or a light emitting element, or a substrate according to the type of the electronic component. For example, when the electronic component is a semiconductor device, the semiconductor device includes at least the substrate, the semiconductor element disposed on the substrate, and the cured product of the LCM material of the present embodiment sealing a gap between the semiconductor element and the substrate. Such a semiconductor device can be manufactured through at least a step of press-clamping after filling the gap between the substrate and the semiconductor element disposed on the substrate with the LCM material of the present embodiment by a compression molding method, and a step of curing the LCM material. Note that the LCM material of the present embodiment is usually a material used for manufacturing various electronic components using compression molding. However, if necessary, it can also be used for manufacturing various electronic components using a molding method other than compression molding.

### [Examples]

Hereinafter, a more specific embodiment will be described by way of examples, however, the embodiment is not limited to only the examples described below.

### 1. Preparation of LCM material

LCM materials of Examples 1 to 20 and Comparative Examples 1 to 3 were prepared by mixing and stirring the raw materials at blending ratios shown in Tables 1 to 3 using the roll mill. Details of the components (A) to (E) used as the raw materials are as follows.

### 2. Raw material components used for preparation of LCM material

### (A) Epoxy resin

- YDF8170 (bisphenol F type epoxy resin, epoxy equivalent: 158 g/eq, manufactured by NIPPON STEEL Chemical & Material Co., Ltd.)
- jER630 (aminophenol epoxy resin, epoxy equivalent: 98 g/eq, manufactured by Mitsubishi Chemical Corporation)
- EPOGOSEY PT (general grade) (aliphatic epoxy resin, epoxy equivalent: 435 g/eq, manufactured by Yokkaichi Chemical Co., Ltd.)

### (B) Curing accelerator

- 2P4MZ (2-phenyl-4-methylimidazole manufactured by Shikoku Chemicals Corporation)
- 2MZA (2,4-diamino-6-[2'-methylimidazolyl-(1')]-ethyl-s-triazine manufactured by Shikoku Chemicals Corporation)
- 2P4MHZ (imidazole compound manufactured by Shikoku Chemicals Corporation)

### (C) Filler

- SE605G-SMG (3-methacryloxypropyltrimethoxysilane surface-treated silicon dioxide, average particle diameter: 1.8 µm, manufactured by Admatechs Co., Ltd.)
- SE1050-SEO (3-glycidoxypropyltrimethoxysilane surface-treated silicon dioxide, average particle diameter: 0.3 µm, manufactured by Admatechs Co., Ltd.)
- STW7010-20 (surface-untreated silicon dioxide, average particle size 10.0 µm, manufactured by NIPPON STEEL & SUMIKIN MATERIALS CO., LTD.)

### (D) Elastomer

- KMP605 (silicone composite powder manufactured by Shin-Etsu Chemical Co., Ltd., elastomer component: 100 mass%)
- CTBN1008SP (carboxyl-terminated butadiene-acrylonitrile copolymer manufactured by CHORI GLEX Co., Ltd., elastomer component: 100 mass%)

*KMP605 is a solid elastomer, and CTBN1008SP is a liquid elastomer having a viscosity of 110 to 160 Pa s at room temperature.

### Masterbatch (mixed composition of component (A) and component (D))

- MX-137 (core-shell type butadiene-based rubber particles manufactured by KANEKA CORPORATION, elastomer component 33 mass% + epoxy resin component 67 mass%)
- MX-965 (core-shell type silicone-based rubber particles manufactured by KANEKA CORPORATION, elastomer component 25 mass% + epoxy resin component 75 mass%)

* 1 For convenience of explanation, the masterbatch is described in the column of elastomer (D) in Tables 1 to 3.
*2 The core-shell type butadiene-based rubber particles and the core-shell type silicone-based rubber particles are solid elastomers.

### (E) Curing agent

- MEH-8005 (phenolic curing agent, hydroxyl equivalent: 139 to 143 g/eq, manufactured by Meiwa Plastic Industries, Ltd.)
- ETHACURE100PLUS (amine-based curing agent manufactured by Albemarle Corporation)
- HN-2200 (acid anhydride-based curing agent manufactured by Showa Denko Materials Co., Ltd.)

### 3. Evaluation of resin-rich matrix

### (1) Preparation of sample for evaluation

The resin-rich matrix was evaluated by the following procedure. First, as shown on the left side of Fig. 1, a silicon wafer 10 (diameter: 12 inches, thickness: 760 µm) was prepared as a member to be resin-sealed (resin-sealing target member). Four silicon chips 20 (length: 18 mm, width: 18 mm, height: 300 µm) are arranged on an upper surface of the silicon wafer 10. Note that the silicon chips 20 were arranged at equal intervals (every 90 degrees) in a circumferential direction along a vicinity of an outer periphery of the silicon wafer 10. Further, as illustrated on the right side of Fig. 1, a total of nine spacers 30 (spacer height: 20 µm) were arranged between the silicon wafer 10 and the silicon chip 20 at equal intervals in an X shape in a planar direction of the silicon chip 20. Next, the inside of the mold was filled with the LCM material, the resin-sealing target member was disposed in the mold, and press clamping was performed. In this way, the compression molding was performed. A sealing layer 40 (cured layer of the LCM material) having a thickness of 500 µm for resin-sealing the silicon chip 20 disposed on the silicon wafer 10 was formed on a molded article thus obtained.

Next, a region including the silicon chip 20 and a vicinity of the silicon chip 20 was cut from the molded article taken out from the mold after the compression molding. A cut piece thus obtained was cut so that a cross-section of a central portion of the silicon chip 20 was exposed. Thus, a sample for evaluation of the resin-rich matrix was obtained.

### (2) Observation of sample for evaluation

The vicinity of the silicon chip 20 of a cut surface of the sample for evaluation was observed using a scanning electron microscope (magnification: 1500 times). Here, when it was confirmed that the resin-rich matrix was formed on a side surface of the silicon chip 20, a maximum thickness of the resin-rich matrix was measured. Evaluation results are shown in Tables 1 to 3. Note that evaluation criteria shown in the tables are as follows. For reference, observation examples of the resin-rich matrix are shown in Figs. 2A to 2C. Note that a black portion in the figures is a resin-rich matrix 50.
A: As illustrated in Fig. 2A, no resin-rich matrix was observed on the side surface of the silicon chip 20.
B: As exemplified in Fig. 2B, the resin-rich matrix having a maximum thickness of less than 2 µm was observed on the side surface of the silicon chip 20.
C: As exemplified in Fig. 2C, the resin-rich matrix having a maximum thickness of 2 µm or more was observed on the side surface of the silicon chip 20.

### 4. Viscosity

### (Viscosity at 25°C)

For a viscosity at 25°C, the viscosity of the LCM material immediately after preparation was measured at a liquid temperature of 25°C and 10 rpm using an HB-DV type viscometer (model number: HB-DV1) manufactured by Brookfield. Note that the evaluation criteria of "determination of viscosity at 25°C" shown in the tables are as follows.
A: viscosity at 25°C is less than 1000 Pa·s
B: viscosity at 25°C is 1000 Pa·s or more

### (Viscosity at 120°C)

In measurement of the viscosity at 120°C, the LCM material (sampling amount: 0.3 ml ± 0.1 ml) was put on a plate heated to 120°C by a viscometer (MARS III manufactured by HAAKE). Next, the measurement of the viscosity was started under measurement conditions of a measurement frequency of 10 Hz, a strain amount of 0.5, a gap of 0.5 mm, and a frequency of 1 second. A viscosity measured 40 seconds after start of the measurement was defined as the viscosity at 120°C.

**[Table 1]**

| | | Comparative Example 1 | Comparative Example 2 | Example 1 | Example 2 | Example 3 | Example 4 | Example 5 | Example 6 | Example 7 |
|---|---|---|---|---|---|---|---|---|---|---|
| (A) Epoxy resin | YDF8170 (*3) | 37.0 | 37.2 | 38.0 | 37.3 | 38.6 | 58.8 | 46.8 | 38.7 | 38.7 |
| | jER630 | 28.4 | 28.1 | 27.8 | 28.2 | 27.6 | 17.7 | 23.8 | 27.6 | 27.6 |
| | EPOGOSEYPT | 34.6 | 34.7 | 34.2 | 34.5 | 33.8 | 23.5 | 29.3 | 33.8 | 33.8 |
| (B) Curing accelerator | 2P4MZ | 4.0 | 4.0 | 3.2 | 3.0 | 2.7 | 2.7 | 2.7 | 2.7 | 2.7 |
| | 2MZA | 0.0 | 0.0 | 0.0 | 0.0 | 0.0 | 0.0 | 0.0 | 0.0 | 0.0 |
| | 2P4MZH | 0.0 | 0.0 | 0.0 | 0.0 | 0.0 | 0.0 | 0.0 | 0.0 | 0.0 |
| (C) Filler | SE605G-SMG | 473.0 | 498.0 | 517.0 | 533.0 | 546.0 | 583.0 | 546.0 | 546.0 | 546.0 |
| | SE1050-SEO | 0.0 | 0.0 | 0.0 | 0.0 | 0.0 | 0.0 | 0.0 | 0.0 | 0.0 |
| | STW7010-20 | 0.0 | 0.0 | 0.0 | 0.0 | 0.0 | 0.0 | 0.0 | 0.0 | 0.0 |
| (D) Elastomer | MX-137 (*1, *2) | 0.0 | 5.0 | 10.0 | 14.0 | 17.0 | 25.0 | 0.0 | 0.0 | 0.0 |
| | MX-965 (*1, *2) | 0.0 | 0.0 | 0.0 | 0.0 | 0.0 | 0.0 | 17.0 | 0.0 | 0.0 |
| | KMP605 | 0.0 | 0.0 | 0.0 | 0.0 | 0.0 | 0.0 | 0.0 | 17.0 | 0.0 |
| | CTBN1008SP | 0.0 | 0.0 | 0.0 | 0.0 | 0.0 | 0.0 | 0.0 | 0.0 | 17.0 |
| (E) Curing agent | MEH-8005 | 0.0 | 0.0 | 0.0 | 0.0 | 0.0 | 0.0 | 0.0 | 0.0 | 0.0 |
| | ETHACURE 100PLUS | 0.0 | 0.0 | 0.0 | 0.0 | 0.0 | 0.0 | 0.0 | 0.0 | 0.0 |
| | HN-2200 | 0.0 | 0.0 | 0.0 | 0.0 | 0.0 | 0.0 | 0.0 | 0.0 | 0.0 |
| Total amount (parts by mass) | A+B+C+D+E | 577.0 | 607.0 | 630.2 | 650.0 | 665.7 | 710.7 | 665.7 | 665.7 | 665.7 |
| Blending ratio of filler (mass%) | C/(A+B+C+D+E) | 82.0 | 82.0 | 82.0 | 82.0 | 82.0 | 82.0 | 82.0 | 82.0 | 82.0 |
| Blending ratio of elastomer (mass%) | D/(A+B+D+E) | 0.0 | 4.6 | 8.8 | 12.0 | 14.2 | 19.6 | 14.2 | 14.2 | 14.2 |
| Viscosity at 25°C | | 90 | 320 | 211 | 328 | 650 | 1350 | 460 | 420 | 630 |
| Viscosity at 120°C | | 0.8 | 1.4 | 1.4 | 1.4 | 1.1 | 1.8 | 1.0 | 1.0 | 1.2 |
| Determination of Viscosity at 25°C | | A | A | A | A | A | B | A | A | A |
| Resin- rich matrix | | C | C | B | A | A | A | A | B | B |

| | | | | | | | | | | |
|---|---|---|---|---|---|---|---|---|---|---|
| *1 Masterbatch obtained by blending and dispersing elastomer in epoxy resin (bisphenol F type epoxy resin with a structure similar to YDF8710) *2 Blending amount of masterbatch (MX-137, MX-965) shown in table means blending amount of elastomer component contained in masterbatch used for preparing LCM material *3 When masterbatch (MX-137, MX-965) is used in preparing LCM material value includes blending amount derived from epoxy resin similar to YDF8710 contained in masterbatch | | | | | | | | | | |

**[Table 2]**

| | | Comparative Example 3 | Example 8 | Example 9 | Example 10 | Example 11 | Example 12 | Example 13 | Example 14 |
|---|---|---|---|---|---|---|---|---|---|
| (A) Epoxy resin | YDF8170 (*3) | 38.6 | 36.3 | 36.1 | 31.2 | 31.3 | 38.4 | 38.4 | 38.4 |
| | jER630 | 27.6 | 29.5 | 29.8 | 33.8 | 33.8 | 27.8 | 27.8 | 27.8 |
| | EPOGOSEYPT | 33.8 | 34.2 | 34.2 | 34.9 | 34.9 | 33.8 | 33.8 | 33.8 |
| (B) Curing accelerator | 2P4MZ | 2.7 | 2.7 | 2.7 | 4.0 | 4.0 | 2.7 | 2.7 | 2.7 |
| | 2MZA | 0.0 | 0.0 | 0.0 | 0.0 | 0.0 | 0.0 | 0.0 | 0.0 |
| | 2P4MZH | 0.0 | 0.0 | 0.0 | 0.0 | 0.0 | 0.0 | 0.0 | 0.0 |
| (C) Filler | SE605G-SMG | 0.0 | 0.0 | 0.0 | 0.0 | 0.0 | 587.0 | 587.0 | 587.0 |
| | SE1050-SEO | 254.0 | 425.0 | 480.0 | 0.0 | 0.0 | 0.0 | 0.0 | 0.0 |
| | STW7010-20 | 0.0 | 0.0 | 0.0 | 687.0 | 1092.0 | 0.0 | 0.0 | 0.0 |
| (D) Elastomer | MX-137 (*1, *2) | 17.0 | 17.0 | 17.0 | 17.0 | 17.0 | 18.3 | 18.3 | 18.3 |
| | MX-965 (*1, *2) | 0.0 | 0.0 | 0.0 | 0.0 | 0.0 | 0.0 | 0.0 | 0.0 |
| | KMP605 | 0.0 | 0.0 | 0.0 | 0.0 | 0.0 | 0.0 | 0.0 | 0.0 |
| | CTBN1008SP | 0.0 | 0.0 | 0.0 | 0.0 | 0.0 | 0.0 | 0.0 | 0.0 |
| (E) Curing agent | MEH-8005 | 0.0 | 0.0 | 0.0 | 0.0 | 0.0 | 7.7 | 0.0 | 0.0 |
| | ETHACURE100PLUS | 0.0 | 0.0 | 0.0 | 0.0 | 0.0 | 0.0 | 7.7 | 0.0 |
| | HN-2200 | 0.0 | 0.0 | 0.0 | 0.0 | 0.0 | 0.0 | 0.0 | 7.7 |
| Total amount (parts by mass) | A+B+C+D+E | 373.7 | 544.7 | 599.7 | 808.0 | 1213.0 | 715.7 | 715.7 | 715.7 |
| Blending ratio of filler (mass%) | C/(A+B+C+D+E) | 68.0 | 78.0 | 80.0 | 85.0 | 90.0 | 82.0 | 82.0 | 82.0 |
| Blending ratio of elastomer (mass%) | D/(A+B+D+E) | 14.2 | 14.2 | 14.2 | 14.0 | 14.0 | 14.2 | 14.2 | 14.2 |
| Viscosity at 25°C | | 47 | 84 | 107 | 610 | 1460 | 950 | 730 | 830 |
| Viscosity at 120°C | | 0.5 | 0.8 | 0.8 | 1.6 | 2.8 | 8.8 | 3.2 | 6.8 |
| Determination of Viscosity at 25°C | | A | A | A | A | B | A | A | A |
| Resin-rich matrix | | C | B | A | A | A | A | A | A |

| | | | | | | | | | |
|---|---|---|---|---|---|---|---|---|---|
| * 1 Masterbatch obtained by blending and dispersing elastomer in epoxy resin (bisphenol F type epoxy resin with a structure similar to YDF8710) *2 Blending amount of masterbatch (MX-137, MX-965) shown in table means blending amount of elastomer component contained in masterbatch used for preparing LCM material *3 When masterbatch (MX-137, MX-965) is used in preparing LCM material, value includes blending amount derived from epoxy resin similar to YDF8710 contained in masterbatch | | | | | | | | | |

**[Table 3]**

| | | Example 15 | Example 16 | Example 17 | Example 18 | Example 19 | Example 20 |
|---|---|---|---|---|---|---|---|
| (A) Epoxy resin | YDF8170 (*3) | 40.0 | 36.5 | 36.5 | 36.5 | 66.2 | 38.8 |
| | jER630 | 27.0 | 28.5 | 28.5 | 28.5 | 0.0 | 44.2 |
| | EPOGOSEY PT | 33.1 | 35.0 | 35.0 | 35.0 | 33.8 | 17.0 |
| (B) Curing accelerator | 2P4MZ | 2.0 | 4.0 | 0.0 | 0.0 | 2.7 | 2.7 |
| | 2MZA | 0.0 | 0.0 | 4.0 | 0.0 | 0.0 | 0.0 |
| | 2P4MZH | 0.0 | 0.0 | 0.0 | 4.0 | 0.0 | 0.0 |
| (C) Filler | SE605G-SMG | 543.0 | 553.0 | 553.0 | 553.0 | 547.0 | 547.0 |
| | SE1050-SEO | 0.0 | 0.0 | 0.0 | 0.0 | 0.0 | 0.0 |
| | STW7010-20 | 0.0 | 0.0 | 0.0 | 0.0 | 0.0 | 0.0 |
| (D) Elastomer | MX-137 (*1, *2) | 17.0 | 17.0 | 17.0 | 17.0 | 17.0 | 17.0 |
| | MX-965 (*1, *2) | 0.0 | 0.0 | 0.0 | 0.0 | 0.0 | 0.0 |
| | KMP605 | 0.0 | 0.0 | 0.0 | 0.0 | 0.0 | 0.0 |
| | CTBN1008SP | 0.0 | 0.0 | 0.0 | 0.0 | 0.0 | 0.0 |
| (E) Curing agent | MEH-8005 | 0.0 | 0.0 | 0.0 | 0.0 | 0.0 | 0.0 |
| | ETHACURE100PLUS | 0.0 | 0.0 | 0.0 | 0.0 | 0.0 | 0.0 |
| | HN-2200 | 0.0 | 0.0 | 0.0 | 0.0 | 0.0 | 0.0 |
| Total amount (parts by mass) | A+B+C+D+E | 662.0 | 674.0 | 674.0 | 674.0 | 666.7 | 666.7 |
| Blending ratio of filler (mass%) | C/(A+B+C+D+E) | 82.0 | 82.0 | 82.0 | 82.0 | 82.0 | 82.0 |
| Blending ratio of elastomer (mass%) | D/(A+B+D+E) | 14.3 | 14.0 | 14.0 | 14.0 | 14.2 | 14.2 |
| Viscosity at 25°C | | 690 | 110 | 120 | 130 | 900 | 410 |
| Viscosity at 120°C | | 1.0 | 1.0 | 1.0 | 1.0 | 2.5 | 1.5 |
| Determination of Viscosity at 25°C | | A | A | A | A | A | A |
| Resin- rich matrix | | A | A | A | A | A | A |

| | | | | | | | |
|---|---|---|---|---|---|---|---|
| *1 Masterbatch obtained by blending and dispersing elastomer in epoxy resin (bisphenol F type epoxy resin with a structure similar to YDF8710) *2 Blending amount of masterbatch (MX-137, MX-965) shown in table means blending amount of elastomer component contained in masterbatch used for preparing LCM material. *3 When masterbatch (MX-137, MX-965) is used in preparing LCM material, value includes blending amount derived from epoxy resin similar to YDF8710 contained in masterbatch | | | | | | | |

### LIST OF REFERENCE SIGNS

- 10: Silicon wafer
- 20: Silicon chip
- 30: Spacer
- 40: Sealing layer
- 50: Resin-rich matrix

## Claims

1. A liquid compression molding material comprising:
an epoxy resin composition containing an epoxy resin (A), a curing accelerator (B), a filler (C), and an elastomer (D), wherein
blending ratio of the filler (C) to the epoxy resin composition is 73.0 mass% or more, and
blending ratio of the elastomer (D) to a total of components excluding the filler (C) from the epoxy resin composition is 7.0 mass% or more.

2. The liquid compression molding material according to claim 1, wherein
the elastomer (D) is at least one kind of substance selected from the group consisting of a solid substance and a liquid substance having a viscosity of 110 Pa s or more at room temperature.

3. The liquid compression molding material according to claim 1 or 2, wherein
the blending ratio of the elastomer (D) to the components excluding the filler (C) from the epoxy resin composition is 7.0 mass% to 16.5 mass%.

4. The liquid compression molding material according to any one of claims 1 to 3, wherein
the blending ratio of the filler (C) to the epoxy resin composition is 73.0 mass% to 87.5 mass%.

5. The liquid compression molding material according to any one of claims 1 to 4, wherein
a viscosity at 120°C is 0.5 Pa s to 40.0 Pa s.

6. The liquid compression molding material according to any one of claims 1 to 5, wherein
the curing accelerator (B) contains a nitrogen-containing heterocyclic compound.

7. The liquid compression molding material according to any one of claims 1 to 6, further comprising a curing agent (E).

8. The liquid compression molding material according to claim 7, wherein
the curing agent (E) contains at least one selected from the group consisting of a phenolic curing agent, an amine-based curing agent, and an acid anhydride-based curing agent.

9. The liquid compression molding material according to any one of claims 1 to 8, wherein
the epoxy resin (A) contains at least one selected from the group consisting of an aliphatic epoxy resin and an aromatic epoxy resin.

10. An electronic component comprising a sealing material containing a cured product of the liquid compression molding material according to any one of claims 1 to 9.

11. A semiconductor device comprising:
a substrate;
a semiconductor element disposed on the substrate; and
the sealing material described in claim 10 that seals a gap between the semiconductor element and the substrate.

12. A method for producing a semiconductor device, the method comprising:
press clamping after a gap between a substrate and a semiconductor element disposed on the substrate is filled with the liquid compression molding material according to any one of claims 1 to 9 by a compression molding method; and
curing of the liquid compression molding material.
